Europäisches Patentamt

European Patent Office

Office européen des brevets

(19)

(11) Publication number: **0 270 067 B1**

(12) # EUROPEAN PATENT SPECIFICATION

(45) Date of publication of patent specification: **19.08.92**

(51) Int. Cl.⁵: **H01L 25/04**, H01L 21/98, H01L 29/60

(21) Application number: **87117737.4**

(22) Date of filing: **01.12.87**

(54) **Method of making a semiconductor device comprising at least two semiconductor chips.**

(30) Priority: **03.12.86 JP 288264/86**

(43) Date of publication of application:
**08.06.88 Bulletin 88/23**

(45) Publication of the grant of the patent:
**19.08.92 Bulletin 92/34**

(84) Designated Contracting States:
**DE FR GB**

(56) References cited:
**EP-A- 0 004 289**
**US-A- 4 067 104**
**US-A- 4 369 458**

**PATENT ABSTRACTS OF JAPAN, vol. 10, no. 133 (E-404)[2190], 17th May 1986; & JP-A-60 262 430**

**IBM TECHNICAL DISCLOSURE BULLETIN, vol. 26, no. 3A, August 1983, pages 927-928, Armonk, New York, US; H.C. JONES et al.: "Plug and socket chip joining"**

(73) Proprietor: **SHARP KABUSHIKI KAISHA**
**22-22 Nagaike-cho Abeno-ku**
**Osaka 545(JP)**

(72) Inventor: **Rai, Akiteru**
**4-10-9, Abenosuji Abeno-ku**
**Osaka-shi Osaka-fu(JP)**
Inventor: **Yamamura, Keiji**
**699-7, Miwa**
**Sakurai-shi Nara-ken(JP)**
Inventor: **Nukii, Takashi**
**39-402, 5-chome Suzaku**
**Nara-shi Nara-ken(JP)**

(74) Representative: **von Kreisler, Alek,**
**Dipl.-Chem. et al**
**Patentanwälte Von Kreisler-Selting-Werner,**
**Deichmannhaus am Hauptbahnhof**
**W-5000 Köln 1(DE)**

## Description

BACKGROUND OF THE INVENTION

(Field of the Invention)

The present invention relates to a method of making a semiconductor device according to the first part of claim 1 and, more particularly, to the method of making a hybrid semiconductor device made up of a stack of semiconductor integrated circuit boards.

(Description of the Prior Art)

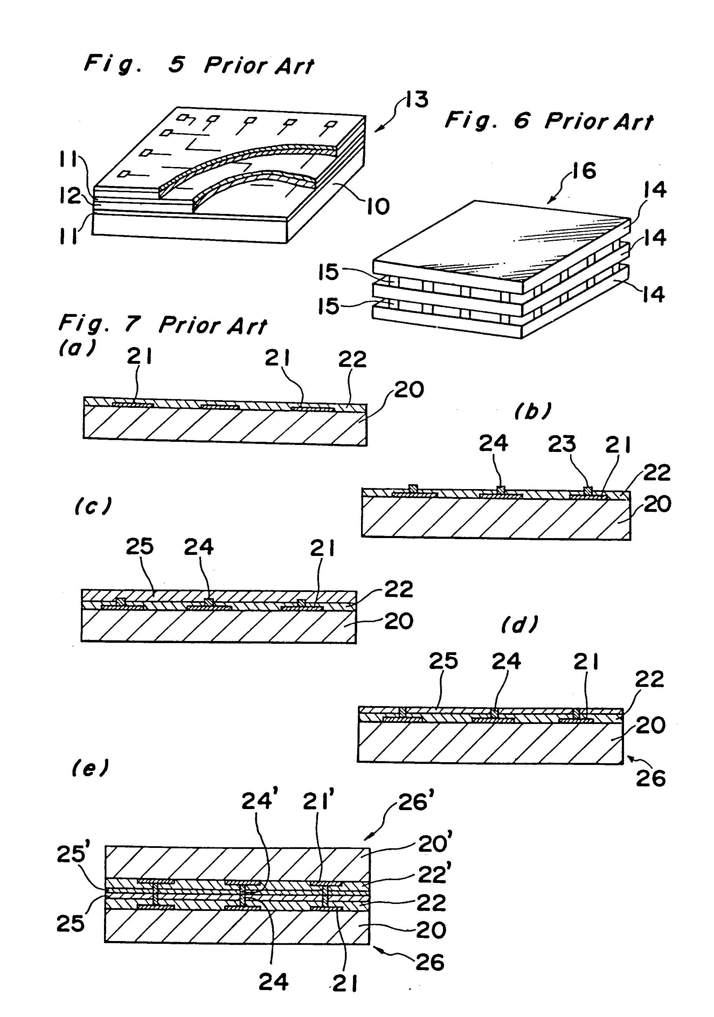

The degree of integration of semiconductor circuit components per chip, that is, the density to which semiconductor components can be fabricated in a single chip, has been rapidly increased as a result of improvement in microprocessing technology and design technique. The outcome of the increased integrating degree is that, in an attempt to provide a high-density, high-performance semiconductor IC device, a three-dimensional integrated circuit is currently devised without altering the existing design requirements. The three-dimensional IC device currently manufactured is available in two types. One is the monolithic type which comprises, as shown in Fig. 5 of the accompanying drawings, a single silicon substrate 10 on which insulating layers 11 and semiconductor layers 12 are alternately stacked one above the other by the use of a chemical vapor deposition technique or the like. The other is the hybrid type which, as shown in Fig. 6 of the accompanying drawings, comprises a plurality of two-dimensional chips 14 mounted one above the other, each neighboring chips 14 being electrically connected by the use of a flip chip bonding technique or the like through a plurality of connecting electrodes 15 that extend in a direction of the thickness of each chip 14.

When it comes to the manufacturing technology and the design, the hybrid semiconductor IC device 16 shown in Fig. 6 has less problems than the monolithic semiconductor IC device 13 and should therefore receive a wide range of application.

However, the hybrid semiconductor IC device known in the art has a detrimental problem in that, since the connecting electrodes 15 are not insulated and are left naked, the pitch P between each neighboring connecting electrodes 15 can no longer be reduced to a value as small as 200$\mu$m. This problem hampers a high-density electrode connection.

In order to obviate the problem discussed in connection with the hybrid semiconductor IC device shown in Fig. 6, such a manufacturing process as shown in Fig. 7 has been proposed. According to the method shown in Fig. 7, the method begins with step (a) at which a plurality of connecting electrodes 21 are formed on an upper surface of an IC substrate 20 and a protective layer 22 is subsequently formed entirely over the upper surface of the substrate 20 so as to cover the connecting electrodes 21. At subsequent step (b), portions of the protective layer 22 are perforated in a depth sufficient to permit the respective electrodes 21 to be exposed to the outside through the resultant perforations 23, followed by the insertion of conductor pieces 24 through the perforations 23, each of the conductor pieces 24 being of a size enough to permit a portion thereof to be exposed outwardly from the protective layer 22. After the insertion of the conductor pieces 24, and as shown by step (c), a resinous bonding agent having an electrically insulating property is applied over the protective layer 22 to form a bonding layer 25 overlaying the conductor pieces 24, followed by step (d) at which the bonding layer 25 is etched off until respective upper regions of the conductor pieces 24 are exposed to the outside to complete a single semiconductor IC unit identified by 26. Then, at step (e), another semiconductor IC unit 26' which comprises a IC substrate 20', electrodes 21', a protective layer 22', conductor pieces 24' and a bonding layer 25' all formed in the manner as hereinbefore described in connection with the semiconductor unit 26 with reference to steps (a) to (d) is placed over the substrate 26 with the conductor pieces 24 in the semiconductor unit 26 exactly aligned with the conductor pieces 24' in the semiconductor unit 26' and the assembly is subsequently hot-pressed to allow the bonding layers 25 and 25' to be bonded together. After the hot-pressing, the conductor pieces 24 in the semiconductor unit 26 and the conductor pieces 24' in the additional semiconductor unit 26' are electrically connected together.

According to the illustrated method of making the hybrid semiconductor IC device, in order for satisfactory and reliable electric connection to be achieved between the conductor pieces 24 in one semiconductor unit 26 and the conductor pieces 24' in the other semiconductor unit 26', it is essential that the upper region of each of the conductor pieces 24 and 24' must be flat and in level with the etched outer surface of the corresponding bonding layer 25, that any one of the substrates 20 and 20' must be free from warp and be flat, and that the semiconductor units 26 and 26' must be uniformly pressed together over the entire surface thereof during the hot press.

Not only does the failure to fulfill these requirements result in unsatisfactory electric connection between some or all of the conductor pieces 24 and 24' which in turn brings about reduction in production yield and reliability, but also much difficulty is involved for both of the technique and the equipment to accomplish these requirements. Moreover, since the temperature and the pressure used during the hot press are fairly high, it often occurs that some or all of semiconductor elements formed on each of the substrates 20 and 20' of the respective semiconductor units 26 and 26' tend to be damaged or, at least, adversely affected.

Other examples of methods for joining semiconductor devices are disclosed in EP-A-0 004 289 and in the IBM Technical Disclosure Bulletin, Vol.26, No.3A, 1983, H.C. Jones et al

## SUMMARY OF THE INVENTION

Accordingly, the present invention has been devised with a view to substantially eliminating the above discussed problems inherent in the prior art method of making the hybrid semiconductor IC devices and has for its essential object to provide an improved method which is effective to provide a high density, high performance semiconductor IC device wherein circuit elements are closely connected and integrated in reliable manner.

To this end, the present invention as disclosed in the characterising portion of claim 1 provides an improved method for making a semiconductor device of a type comprising at least first and second semiconductor circuit boards or units positioned one above the other, which method comprises the formation of a plurality of connecting electrodes on an upper surface of each of at least first and second semiconductor substrates and, also, of a electrically insulating layer entirely over the upper surface of each of the first and second substrates so as to cover the respective connecting electrodes. Subsequently, portions of the insulating layer on each of the first and second substrates are partially removed to permit the respective electrodes to be exposed to the outside.

Thereafter, metal studs are formed on the first substrate in contact with the electrodes so as to protrude outwardly of the respective insulating layer to complete the first semiconductor unit and, on the other hand, solder deposits are formed on the second substrate in contact with the respective electrodes on such second substrate to complete the second semiconductor unit. The first and second semiconductor units are placed one above the other with the metal studs in the first semiconductor unit aligned respectively with the solder deposits in the second semiconductor unit, and the resultant assembly is then heated to allow the solder deposits to be melted with the associated metal studs consequently immersed into the melted solder deposits. Thus, when the assembly is cooled with the solder deposits solidified, rigid and reliable electric connection can be accomplished between the metal studs and the solder deposits.

According to the present invention, the satisfactory and reliable electric connection can be achieved between the electrodes in the first and second semiconductor units with no substantial reduction in production yield and reliability being accompanied. Moreover, since the high temperature and the high pressure used during the hot press are not employed, there is no substantial possibility that some or all of semiconductor elements formed on each of the substrates of the respective semiconductor units may be damaged or, at least, adversely affected.

The dependent claims describe particular embodiments of the invention.

Furthermore, the method according to the present invention can enhance the high density integration of IC circuit components which would ultimately bring about reduction in circuit operating speed.

## BRIEF DESCRIPTION OF THE DRAWINGS

This and other objects and features of the present invention will become clear from the following description taken in conjunction with preferred embodiments thereof with reference to the accompanying drawings, in which:

Fig. 1(I) is a sectional view of one of semiconductor units used in a semiconductor IC device according to a preferred embodiment of the present invention;

Fig. 1(II) is a sectional view of the other of the semiconductor units to be used in combination with the semiconductor unit of Fig. 1(I) to complete the semiconductor IC device;

Fig. 1(III) is a sectional view of the semiconductor IC device formed of the semiconductor units of Figs. 1(I) and 1(II);

Figs. 2 to 4 are views similar to Figs. 1(I) to 1-(III), respectively, showing different embodiments of the present invention;

Figs. 5 and 6 are schematic perspective views of the prior art monolithic and hybrid semiconductor IC devices; and

Fig. 7 illustrates the sequence of the prior art method of making the hybrid semiconductor IC device.

## DETAILED DESCRIPTION OF THE EMBODIMENTS

Referring first to Fig. 1(I), a method for making a semiconductor device according to the present invention provides a hybrid semiconductor IC device of a type comprising at least first and second semiconductor circuit boards or units positioned one above the other while electrodes 2 and 2' in the respective first and second semiconductor units electrically connected together.

As shown in Figs. 1(I) and 1(II), each of the first and second semiconductor circuit units comprises a semiconductor substrate 1 or 1' having operating elements formed thereon. The respective semiconductor substrate 1 or 1' also has a a plurality of electrodes 2 or 2' deposited in any known manner on an upper major surface of the substrate 1 or 1', each neighboring members of the electrodes 2 or 2' being spaced a predetermined distance from each other. Each electrodes 2 and 2' may be made of any known material, for example, aluminum.

An electrically insulating layer 3 or 3' made of, for example, $SiO_2$ or SiN is formed over the associated substrate 1 or 1' in each of the semiconductor circuit units so as to cover the electrodes 2 or 2'. Subsequently, portions of the insulating layer 3 or 3' on each of the first and second substrates 1 or 1' are partially removed to permit the respective electrodes 2 or 2' to be exposed to the outside while leaving corresponding holes in the insulating layer 3 or 3' in register with the associated electrodes 2 or 2'.

Thereafter, as best shown in Fig. 1(I), metal studs 4 made of, for example, Cu or Au are formed on the first substrate 1 in contact with the electrodes so as to protrude outwardly of the respective insulating layer 3 to complete the first semiconductor unit. On the other hand, as best shown in Fig. 1(II), solder deposits 5 made of, for example, Sn, Pb or In are filled in the respective holes in the insulating layer 3' on the second substrate 1' so as to contact the respective electrodes 2' on such second substrate 1' thereby to complete the second semiconductor unit.

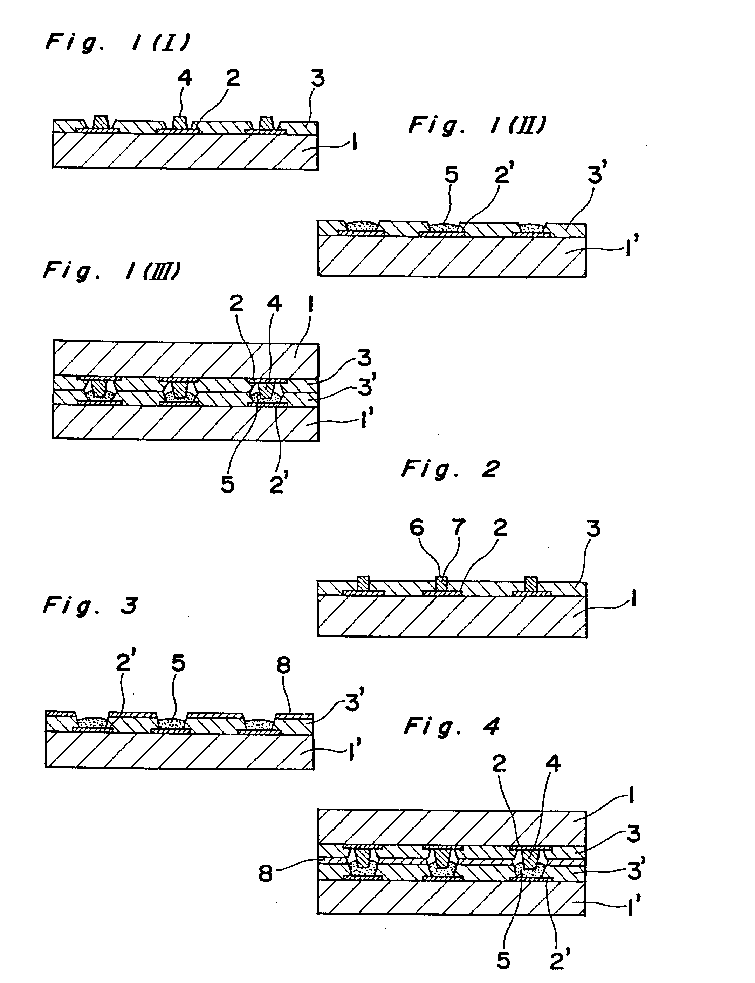

The first and second semiconductor units are, as best shown in Fig. 1(III), placed one above the other with the metal studs 4 in the first semiconductor unit 1 aligned respectively with the solder deposits 5 in the second semiconductor unit 1', and the resultant assembly is then heated. During the heating, the solder deposits 5 are melted to accommodate the associated metal studs 4 then immersed into the melted solder deposits 5. It is to be noted that the amount of each of the solder deposits 5 filled in the respective hole in the insulating layer 3' is so selected that, when it is melted during the heating of the assembly of first and second semiconductor units 1 and 1' as hereinbefore described, the melted solder deposit 5 undergoing thermal expansion will not spread on the outer surface of the respective insulating layer 3'.

Thus, when the assembly is cooled with the solder deposits solidified, the metal studs 4 are firmly interlocked with the solder deposits 5 thereby to accomplish a rigid and reliable electric connection between the electrode 2 on the first substrate 1 and the electrodes 2' on the second substrate 2', thereby completing the hybrid semiconductor IC device.

The temperature used to melt the solder deposits 5 in the practice of the method of the present invention is fairly lower than that used during the hot pressing according to the prior art method described with reference to Fig. 7. Moreover, no pressure so high as in the practice of the prior art method is applied to the assembly of the first and second semiconductor units according to the method of the present invention. Therefore, not only is the possibility of the operating elements formed on each of the substrates 1 and 1' be minimized or substantially eliminated, but also no substantially strict management of requirements associated with the electrode-to-electrode connection is required in the practice of the method of the present invention.

In the foregoing embodiment, the insulating layer 3 or 3' has been described as partially removed to form the holes in alignment with the associated electrodes 2 or 2'. However, in the embroilments in Fig. 2, the insulating layer 3 or 3' is perforated at locations in alignment with the associated electrodes 2 or 2' to form the holes for accommodating the metal studs, now identified by 6, of generally cylindrical shape or the solder deposits 5, respectively, it being to be understood that each of the perforated holes for accommodating the cylindrical metal studs 4 has a diameter enough for the associated cylindrical metal stud 4 to be readily inserted into such perforated hole.

The second semiconductor unit which can be used in the practice of the method of the present invention may be modified such as shown in Fig. 3. According to the embodiment shown in Fig. 3, an electrically insulating bonding agent is applied to the outer surface of the insulating layer 3' to form a bonding layer 8 thereby to complete the modified second semiconductor unit. After the formation of the bonding layer 8 overlaying the insulating layer 3', that is, after the formation of the modified second substrate unit, the first semiconductor unit shown in and described with reference to Fig. 1(I) is placed over the modified second substrate unit as shown in Fig. 4 to bond the insulating layers 3 and 3' together through the bonding layer 8 and the assembly of first and modified second semiconductor units is, then, heated in a manner as hereinbefore described to interlock the metal studs 4 or 6 with the solder deposits 5.

According to the embodiment shown in and described with reference to Figs. 3 and 4, since not only are the metal studs 4 or 6 firmly interlocked with the solder deposits 5 to connect the electrodes 2 and 2' together, but also the insulating layers 3 and 3' are bonded or connected together, that is, since the first semiconductor unit is held in tight contact with the modified second semiconductor unit substantially over the entire surface thereof, the first and modified second semiconductor units can be firmly bonded together with the electrodes 2 firmly connected with the electrodes 2', thereby providing the semiconductor IC device having an improved reliability. It is to be noted that a similar bonding layer may be also formed on the insulating layer 3 in the first semiconductor unit.

Although the present invention has been fully described in connection with the preferred embodiments thereof with reference to the accompanying drawings, it is to be noted that some modification are described below by way of example. If desired, a metal layer may be interposed between each of the metal studs 4 or 6 and the associated electrode 2, and/or between each of the electrodes 2' and the associated solder deposit 5.

Also, although reference has been made to the use of the two semiconductor units to form the single semiconductor IC device, three or more semiconductor units may be employed. Specifically, where the three semiconductor units are used, one of the semiconductor substrates in the respective semiconductor units which would be positioned intermediate between the other semiconductor substrates may have its opposite major surfaces provided with the metal studs or the solder deposits.

## Claims

1.  A method for making a semiconductor device of a type comprising at least first and second semiconductor circuit units, which method comprises the step of;
    forming a plurality of connecting electrodes (2 and 2') on an upper surface of each of at least first and second semiconductor substrates (1 and 1');
    characterized by forming an electrically insulating layer (3 and 3') entirely over the upper surface of each of the first and second substrates (1 and 1') so as to cover the respective connecting electrodes (2 and 2');
    partially removing the insulating layer (3 and 3') on each of the first and second substrates (1 and 1') forming holes to permit the respective electrodes (2 and 2') to be exposed to the outside;
    forming metal studs (4 or 7) on the first substrate (1) in contact with the electrodes (12) so as to protrude outwardly of the respective insulating layer (3) to complete the first semiconductor unit and forming solder deposits (5) on the second substrate (1') by filling up respective portions of said holes in the insulating layer (3') of the second substrate (1') in contact with the respective electrodes (2') on such second substrate (1') to complete the second semiconductor unit;
juxtaposing the first and second semiconductor units with the metal studs (4 or 7) in the first semiconductor unit aligned respectively with the solder deposits (5) in the second semiconductor unit; and
heating the resultant assembly to allow the solder deposits (5) to be melted with the associated metal studs (4 or 7) consequently immersed into the melted solder deposits (5) thereby to accomplish a firm interlock between the electrodes (2 and 2') on the first and second substrates (1 and 1').

2.  A method according to claim 1,
    whereby the studs (7) are cylindrically shaped.

3.  A method according to claim 1 or 2 characterized by inserting a bonding agent (8) between the insulating layers (3 and 3') of said first and second semiconductor circuit unit.

4.  A method according to claims 1 to 3 characterized by forming perforated holes in said second semiconductor circuit unit when partially removing said insulating layer (3').

## Patentansprüche

1.  Verfahren zur Herstellung einer Halbleiter-Vorrichtung eines Typs mit wenigstens einer ersten und einer zweiten Halbleiterschaltungs-Einheit, umfassend den Schritt des Ausbildens einer Mehrzahl verbindender Elektroden (2 und 2') auf einer oberen Oberfläche jedes der wenigstens einen ersten und zweiten Halbleiter-Substrate (1 und 1'); gekennzeichnet durch
    das Ausbilden einer elektrisch isolierenden Schicht (3 und 3') über der gesamten Oberfläche jedes der ersten und zweiten Substrate (1 und 1'), so daß sie die jeweiligen verbindenden Elektroden (2 und 2') bedeckt;
    das partielle Entfernen der isolierenden Schicht (3 und 3') auf jedem der ersten und zweiten Substrate (1 und 1') zur Bildung von Löchern, durch die die betreffenden Elektroden (2 und 2') zur Außenseite hin freigelegt werden;
    das Bilden von Metallbolzen (4 oder 7) auf dem ersten Substrat (1) in Kontakt mit den Elektroden (12) in der Weise, daß sie aus der betreffenden Isolierschicht (3) nach außen hervorstehen, um die erste Halbleiter-Einheit zu vervollständigen, und das Bilden von Lot-Abscheidungen (5) auf dem zweiten Substrat (1') durch Füllen der betreffenden Teile der Löcher in der Isolierschicht (3') des zweiten Substrats (1') in Kontakt mit den betreffenden Elektroden (2') auf diesem zweiten Substrat (1'), um die zweite Halbleiter-Einheit zu vervollständigen;

das Aneinanderlegen der ersten und zweiten Halbleiter-Einheit unter Ausrichtung der Metallbolzen (4 oder 7) in der ersten Halbleiter-Einheit mit den Lot-Abscheidungen (5) in der zweiten Halbleiter-Einheit; und

das Erhitzen der resultieren Baugruppe, um ein Aufschmelzen der Lot-Abscheidungen (5) zu ermöglichen, so daß folglich die zugehörigen Metallbolzen (4 oder 7) in die geschmolzenen Lot-Abscheidungen eintauchen, um dadurch eine feste Verblockung zwischen den Elektroden (2 und 2') auf dem ersten und zweiten Substrat (1 und 1') zu bewerkstelligen.

2. Verfahren nach Anspruch 1, worin die Bolzen (7) eine zylindrische Form haben.

3. Verfahren nach Anspruch 1 oder Anspruch 2, gekennzeichnet durch das Einfügen eines Bindemittels (8) zwischen den Isolierschichten (3 und 3') der ersten und der zweiten Halbleiterschaltungs-Einheit.

4. Verfahren nach den Ansprüchen 1 bis 3, gekennzeichnet durch das Bilden von Perforationslöchern in der zweiten Halbleiterschaltungs-Einheit beim partiellen Entfernen der Isolierschicht (3').

**Revendications**

1. Procédé de fabrication d'un dispositif semi-conducteur d'un type comprenant au moins des première et seconde unités de circuit semi-conductrices, procédé qui comprend l'étape consistant à:

former une multiplicité d'électrodes de connexion (2 et 2') sur une surface supérieure de chacun d'au moins un premier et un second substrats semi-conducteurs (1 et 1'); caractérisé en ce qu'il consiste à former une couche électriquement isolante (3 et 3') couvrant entièrement la surface supérieure de chacun des premier et second substrats (1 et 1') de manière à recouvrir les électrodes de connexion respectives (2 et 2');

à éliminer partiellement la couche isolante (3 et 3') sur chacun des premier et second substrats (1 et 1') en formant des trous pour permettre aux électrodes respectives (2 et 2') d'être exposées à l'extérieur;

à former des plots métalliques (4 ou 7) sur le premier substrat (1) en contact avec les électrodes (2) de manière à ce qu'ils fassent saillie à l'extérieur de la couche isolante respective (3) pour achever la première unité semi-conductrice, et à former des dépôts de soudure (5) sur le second substrat (1') en remplissant des parties respectives desdits trous de la couche isolante (3') du second substrat (1') en contact avec les électrodes respectives (2') sur ledit second substrat (1') pour achever la seconde unité semi-conductrice;

à juxtaposer les première et seconde unités semi-conductrices, en alignant les plots métalliques (4 ou 7) de la première unité semi-conductrice respectivement avec les dépôts de soudure (5) de la seconde unité semi-conductrice; et

à chauffer l'assemblage résultant pour permettre aux dépôts de soudure (5) de fusionner avec les plots métalliques associés (4 ou 7), qui sont immergés par conséquent dans les dépôts de soudure fondus (5) pour réaliser ainsi un verrouillage réciproque solide entre les électrodes (2 et 2') des premier et second substrats (1 et 1').

2. Procédé selon la revendication 1, dans lequel les plots (7) sont de forme cylindriques.

3. Procédé selon la revendication 1 ou 2, caractérisé en ce qu'un agent de liaison (8) est inséré entre les couches isolantes (3 et 3') desdites première et seconde unités de circuit semi-conductrices.

4. Procédé selon les revendications 1 à 3, caractérisé en ce que des trous perforés sont formés dans ladite seconde unité de circuit semi-conductrice lorsque ladite couche isolante (3') est partiellement éliminée.

Fig. 1(I)

Fig. 1(II)

Fig. 1(III)

Fig. 2

Fig. 3

Fig. 4

Fig. 5 Prior Art

Fig. 6 Prior Art

Fig. 7 Prior Art
(a)
(b)
(c)
(d)
(e)